(19) Europäisches Patentamt
European Patent Office
Office européen des brevets

(11) **EP 1 890 122 A1**

(12) **DEMANDE DE BREVET EUROPEEN**

(43) Date de publication:
**20.02.2008 Bulletin 2008/08**

(51) Int Cl.:
*G01K 1/02* *(2006.01)*    *H03M 1/18* *(2006.01)*

(21) Numéro de dépôt: **07113686.5**

(22) Date de dépôt: **02.08.2007**

(84) Etats contractants désignés:
**AT BE BG CH CY CZ DE DK EE ES FI FR GB GR HU IE IS IT LI LT LU LV MC MT NL PL PT RO SE SI SK TR**
Etats d'extension désignés:
**AL BA HR MK YU**

(30) Priorité: **18.08.2006 FR 0653397**

(71) Demandeur: **Stmicroelectronics Maroc 20250 Casablanca (MA)**

(72) Inventeurs:
• **Vogt, Lionel**
 **44700, Orvault (FR)**
• **Chara, Youness**
 **CASABLANCA (MA)**

(74) Mandataire: **de Beaumont, Michel**
 **Cabinet Beaumont**
 **1, rue Champollion**
 **38000 Grenoble (FR)**

(54) **Capteur de température fournissant un signal de température sous forme numérique**

(57)    L'invention concerne un capteur de température fournissant un signal numérique (Code) représentatif de la température, comportant :

un module de mesure (30) fournissant un premier courant de mesure ($I_1$) égal à la somme d'au moins un premier courant proportionnel à la température et d'un deuxième courant ($I_{DP}$) ;

un comparateur (20) adapté à fournir un signal de comparaison ($V_{COMP}$) qui dépend de la comparaison entre le premier courant et la différence entre un troisième courant ($I_{DN}$) et le deuxième courant ($I_{DP}$) ;

un module de codage (22) recevant le signal de comparaison et fournissant ledit signal numérique ;

un convertisseur numérique-analogique (24) adapté à fournir le second courant et le troisième courant, ladite différence correspondant à la conversion dudit signal numérique ; et

un module (18, 34) de fourniture d'une tension de référence ($V_{REF}$).

Fig 4

EP 1 890 122 A1

**Description**

Domaine de l'invention

La présente invention concerne un capteur de température fournissant un signal représentatif de la température sous forme numérique.

Exposé de l'art antérieur

La tendance actuelle est à la fabrication de circuits intégrés réalisant des fonctions de plus en plus nombreuses et complexes. Ceci entraîne une augmentation de la chaleur dissipée dans le circuit intégré. Pour des raisons de performances et de fiabilité, il devient alors nécessaire de prévoir un dispositif de contrôle de la température du circuit intégré pour maintenir le circuit dans une plage de températures acceptables. Le dispositif de contrôle comprend généralement un capteur de température réalisé de façon intégrée.

Le capteur de température doit satisfaire plusieurs contraintes :

- il doit fournir un signal représentatif de la température du circuit intégré sous une forme numérique directement utilisable ;
- il doit fournir un signal représentatif de la température avec une précision suffisante ;
- il doit fonctionner de façon convenable dans un environnement numérique bruité ;
- le réglage, ou étalonnage, du capteur doit être simple ; et
- le procédé de fabrication du capteur doit être compatible avec les procédés de fabrication CMOS.

Pour satisfaire ces contraintes, différents circuits de capteurs de température ont été proposés.

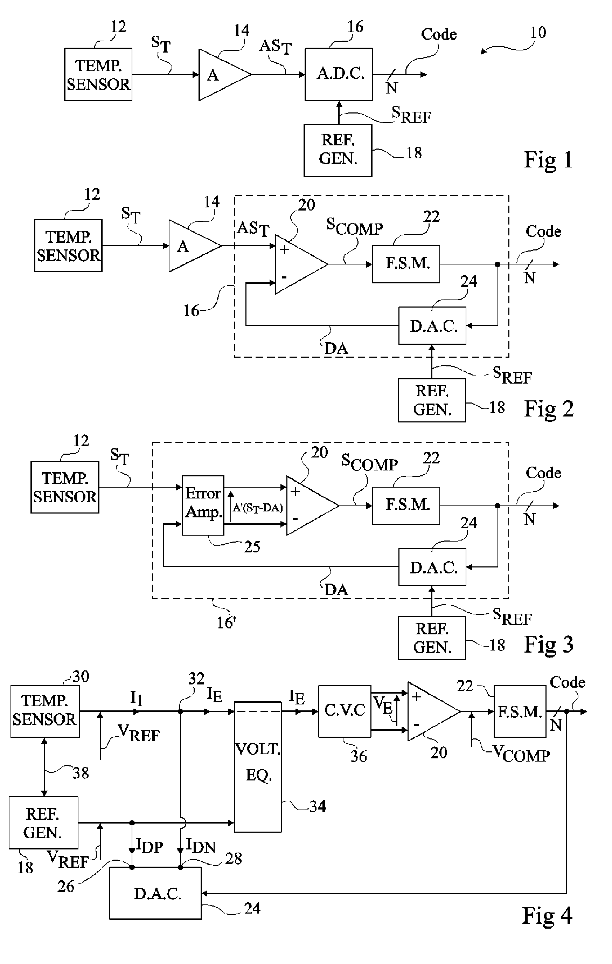

La figure 1 représente, de façon schématique, un exemple de réalisation classique d'un capteur de température 10 fournissant un signal représentatif de la température sous forme numérique.

Le capteur 10 comprend un module de mesure de température 12 (TEMP. SENSOR) fournissant un signal analogique $S_T$ représentatif de la température. Un amplificateur 14 (A) reçoit le signal $S_T$ et fournit un signal amplifié $AS_T$. Un convertisseur analogique-numérique 16 (A.D.C.) convertit le signal $AS_T$ en un signal numérique Code, codé sur N bits, représentatif de la température. Le fonctionnement du convertisseur 16 requiert généralement un signal de référence $S_{REF}$ constant fourni par un module de génération de signal de référence 18 (REF. GEN.).

De façon typique, le signal $S_T$ correspond à une tension variant entre 45 et 75 mV, respectivement pour -40°C et +125°C, ce qui représente une variation de 30 mV. La plupart des convertisseurs analogique-numérique nécessitent que les tensions analogiques qui leur sont fournies soient dans une plage de 0 à 1 V. Il est donc nécessaire que l'amplificateur 14 ait un facteur d'amplification élevé et précis. En effet, une imprécision au niveau de l'amplificateur 14 se traduirait par une imprécision importante du signal numérique Code fourni. En outre, bien qu'amplifié, le signal $AS_T$ conserve une pente limitée, typiquement de l'ordre de 5 mV/K. La réalisation du convertisseur analogique-numérique 16 peut alors être délicate. En effet, si l'on souhaite que le bit de poids le moins significatif du signal Code représente 1 K, celui-ci doit traduire une variation du signal $AS_T$ de 5 mV. La réalisation d'un amplificateur 14 et d'un convertisseur analogique-numérique 16 de haute précision se traduit par l'obtention d'un capteur de température 10 occupant une grande surface du circuit intégré et ayant une consommation élevée.

Résumé de l'invention

La présente invention vise un capteur de température fournissant un signal représentatif de la température sous forme numérique qui peut être réalisé de façon intégrée en occupant une surface réduite et en ayant une consommation limitée.

Selon un autre objet de la présente invention, la résolution du capteur de température peut être facilement modifiée.

Selon un autre objet de la présente invention, le paramétrage du capteur de température peut être réalisé de façon simple.

Pour atteindre tout ou partie de ces objets ainsi que d'autres, la présente invention prévoit un capteur de température fournissant un signal numérique représentatif de la température, comportant un module de mesure fournissant un premier courant de mesure égal à la somme d'au moins un premier courant proportionnel à la température et d'un deuxième courant ; un comparateur adapté à fournir un signal de comparaison qui dépend de la comparaison entre le premier courant et la différence entre un troisième courant et le deuxième courant ; un module de codage recevant le signal de comparaison et fournissant ledit signal numérique ; un convertisseur numérique-analogique à commutation de courant adapté à fournir le second courant à une première borne de sortie et le troisième courant à une seconde borne de sortie, ladite différence correspondant à la conversion dudit signal numérique, le module de mesure étant relié à la première borne de sortie ; et un module de fourniture d'une tension de référence aux première et seconde bornes de sortie ayant une valeur distincte de la tension de masse du capteur.

Selon un mode de réalisation de la présente invention, le capteur comporte un module de fourniture de ladite tension de référence à la première borne de sortie et un module adapté à appliquer la tension de référence à la seconde borne de sortie.

Selon un mode de réalisation de la présente invention, le capteur comporte un premier amplificateur opérationnel ayant une première entrée reliée à la première borne de sortie et une seconde entrée reliée à la seconde borne de sortie, et une résistance reliant la seconde entrée et la sortie du premier amplificateur opérationnel, le comparateur comportant un second amplificateur opérationnel ayant des troisième et quatrième entrées, la tension aux bornes de la résistance étant appliquée entre les troisième et quatrième entrées du second amplificateur opérationnel.

Selon un mode de réalisation de la présente invention, le signal numérique comporte un nombre entier N de bits de rangs 0 à N-1, le bit de rang N-1 étant de poids le plus significatif, et le convertisseur numérique-analogique est un réseau en échelle comportant N cellules successives, comportant chacune un noeud d'entrée, un noeud intermédiaire et un noeud de sortie ; une première résistance à une première valeur de résistance entre le noeud d'entrée et le noeud intermédiaire ; une deuxième résistance à une deuxième valeur de résistance entre le noeud intermédiaire et le noeud de sortie, le noeud de sortie d'une cellule de rang i, où i est un entier compris entre 0 et N-2, étant relié au noeud intermédiaire de la cellule de rang i+1 ; et un interrupteur adapté à relier le noeud d'entrée à la première borne de sortie ou à la seconde borne de sortie en fonction de la valeur du bit de rang i dudit signal numérique ; le noeud de sortie de la cellule de rang N-1 est relié à la masse du capteur, une troisième résistance à la première valeur de résistance reliant le noeud intermédiaire de la cellule de rang 0 à la seconde borne de sortie.

Selon un mode de réalisation de la présente invention, le capteur comporte en outre une quatrième résistance reliant le noeud de sortie de la cellule de rang N-1 à la seconde borne de sortie.

Selon un mode de réalisation de la présente invention, le module de fourniture de la tension de référence comprend des premier et second transistors bipolaires dont les bases et les collecteurs sont reliés à la masse du capteur ; un amplificateur opérationnel ayant une première entrée reliée à la première borne de sortie par l'intermédiaire d'une première résistance et à l'émetteur du premier transistor et une seconde entrée reliée à la première borne de sortie par l'intermédiaire d'une deuxième résistance et à l'émetteur du second transistor par l'intermédiaire d'une troisième résistance, ledit amplificateur opérationnel fournissant une tension de commande ; et une source de courant commandée par la tension de commande et reliée à la première borne de sortie.

Selon un mode de réalisation de la présente invention, le module de mesure comprend une source de courant supplémentaire commandée par la tension de commande et reliée à la seconde borne de sortie.

Brève description des dessins

Ces objets, caractéristiques et avantages, ainsi que d'autres de la présente invention seront exposés en détail dans la description suivante d'un exemple de réalisation particulier faite à titre non-limitatif en relation avec les figures jointes parmi lesquelles :

la figure 1, précédemment décrite, représente un exemple de réalisation classique d'un capteur de température ;
la figure 2 représente un autre exemple de réalisation d'un capteur de température ;
la figure 3 représente un exemple de réalisation d'un capteur de température selon l'invention ;
la figure 4 représente un exemple de réalisation plus détaillé du capteur de température de la figure 3 ; et
la figure 5 représente un exemple de réalisation plus détaillé du capteur de température de la figure 4.

Par souci de clarté, de mêmes éléments ont été désignés par de mêmes références aux différentes figures.

Description détaillée

La présente invention a été développée à partir de l'analyse d'un convertisseur analogique-numérique 16 ayant une structure particulière.

La figure 2 représente un capteur de température comportant un convertisseur analogique-numérique 16 à boucle de rétroaction qui comprend un comparateur 20 recevant, à l'entrée positive (+), le signal amplifié $AS_T$ et fournissant un signal binaire $S_{COMP}$ à un module de codage 22, par exemple une machine à états finis (F.S.M.). Le module de codage 22 fournit le signal binaire Code correspondant à la conversion numérique du signal $AS_T$. Un convertisseur numérique-analogique 24 (D.A.C.) reçoit le signal numérique Code et le convertit en un signal analogique DA fourni à l'entrée négative (-) du comparateur 20. Le signal de référence $V_{REF}$ est fourni au convertisseur 24.

Le convertisseur analogique-numérique 16 peut fonctionner selon un procédé par approximations successives ou par rampe numérique. A titre d'exemple, avec le procédé de fonctionnement par approximations successives, le module 22 fournit initialement un signal Code pour lequel le bit de poids le plus significatif est à "1", les autres bits étant à "0", ce qui correspond donc à la valeur médiane susceptible d'être codée par le signal Code. En fonction du résultat de la comparaison du signal DA, correspondant à la conversion du signal Code, et du signal $AS_T$, le bit de poids le plus significatif du signal Code est maintenu à "1" ou mis à "0". Le procédé est répété successivement pour les bits de poids de moins en moins significatif jusqu'au bit le moins significatif. Le signal Code finalement obtenu correspond à la conversion numérique du signal $AS_T$.

En appelant $b_i$, i étant un entier variant entre 0 et N-1, les bits successifs du signal Code, $b_{N-1}$ étant le bit de poids le plus significatif, le signal DA peut s'écrire de la façon suivante :

$$DA = \frac{DA_{FS}}{2^N - 1}(b_{N-1} \cdot 2^{N-1} + b_{N-2} \cdot 2^{N-2} + ... + b_1 \cdot 2^1 + b_0 \cdot 2^0) + DA_0 \quad (1)$$

où $DA_{FS}$ est l'excursion du signal DA (correspondant au terme anglais full scale swing) et $DA_0$ est la valeur du signal DA lorsque tous les bits du signal Code sont à "0".

Lorsque le procédé de conversion est achevé, le signal DA vérifie l'équation suivante :

$$A \cdot S_T - DA = 0 \qquad (2)$$

en négligeant l'erreur restante, qui est inférieure à la valeur analogique correspondant au bit de poids le moins significatif du signal Code.

A partir des équations (1) et (2), on obtient l'équation suivante :

$$b_{N-1} \cdot 2^{N-1} + ... + b_1 \cdot 2^1 + b_0 \cdot 2^0 = (2^N - 1)\frac{A \cdot S_T - DA_0}{DA_{FS}} \qquad (3)$$

Si le signal $S_T$ est proportionnel à la température absolue, et si les valeurs $DA_0$ et $DA_{FS}$ sont obtenues à partir d'un signal de référence indépendant de la température, le signal Code est bien une représentation numérique linéaire de la température.

Les paramètres $DA_{FS}$ et $DA_0$ peuvent être fixés pour permettre le codage d'une température T appartenant à n'importe quelle plage de températures $[T_0, T_1]$, où $T_0$ est la température minimale de fonctionnement du capteur et correspond à la valeur du signal Code pour laquelle tous les bits sont à "0", et où $T_1$ est la température maximale de fonctionnement du capteur et correspond à la valeur du signal Code pour laquelle tous les bits sont à "1". En effet, le signal $S_T$ étant proportionnel à la température absolue T, il peut s'exprimer de la façon suivante :

$$A \cdot S_T = B \cdot T \qquad (4)$$

où B est un terme constant.

Pour la valeur du signal Code (0,...,0), on a :

$$0 = (2^N - 1)\frac{B \cdot T_0 - DA_0}{DA_{FS}} \qquad (5)$$

Pour la valeur du signal Code (1, ...,1), on a :

$$2^N - 1 = (2^N - 1)\frac{B \cdot T1 - DA_0}{DA_{FS}} \qquad (6)$$

A partir des équations (5) et (6), on obtient les expressions des paramètres $DA_{FS}$ et $DA_0$ de la façon suivante :

$$DA_0 = B \cdot T_0 \qquad (7)$$

$$DA_{FS} = B \cdot (T_1 - T_0) \qquad (8)$$

Il est donc possible de choisir arbitrairement la plage de températures de fonctionnement du capteur en fixant la valeur minimale et l'excursion du convertisseur numérique-analogique 24 à partir des équations (7) et (8).

Entre les températures $T_0$ et $T_1$, le signal Code est obtenu à partir de l'équation suivante :

$$b_{N-1} \cdot 2^{N-1} + ... + b_1 \cdot 2^1 + b_0 \cdot 2^0 = (2^N - 1)\frac{T - T_0}{T_1 - T_0} \qquad (9)$$

Un inconvénient d'un tel convertisseur 16 est qu'il peut être difficile d'obtenir simultanément un amplificateur 14 et un convertisseur numérique-analogique 24 qui soient simples à réaliser. En effet, supposons que pour $T_0$ égal à 233 K, $S_T$ soit égal à 45 mV et que pour $T_1$ égal à 398 K, $S_T$ soit égal à 75 mV. Pour un facteur d'amplification A égal à 33, $DA_0$ est égal à 1,5 V et $DA_{FS}$ est égal à 2,5 V. Un tel facteur d'amplification A est en pratique très difficile à obtenir avec la précision nécessaire : par exemple, une erreur de 1% sur ce facteur provoque une erreur supérieure à 3 degrés celsius. Pour un facteur d'amplification A plus facile à obtenir, par exemple égal à 10, $DA_0$ est égal à 0,45 V et $DA_{FS}$ est égal à 0,75 V. Dans ce cas, ce sont les valeurs des paramètres $DA_0$ et $DA_{FS}$ qui sont difficiles à obtenir avec précision.

La figure 3 représente un capteur de température comportant un convertisseur analogique-numérique 16' modifié par rapport au convertisseur analogique-numérique 16 de la figure 2. En particulier, le convertisseur 16' comprend un module d'amplification d'erreur 25 recevant le signal $S_T$ et le signal DA et fournissant un signal A' ($S_T$-DA) entre les bornes du comparateur 20. Par rapport au capteur de la figure 2, l'amplificateur 14 n'est pas présent. Le signal A'($S_T$-DA) correspond à la différence entre les signaux $S_T$ et DA, cette différence étant amplifiée par le gain A'. Avec une telle structure de convertisseur 16', on réalise la différence entre les signaux $S_T$ et DA avant amplification. Le gain A' n'est donc pas nécessairement précis puisque seul le signe de la différence entre les signaux $S_T$ et DA importe. De ce fait, seul le décalage (offset) apporté par le module d'amplification 25 peut avoir une incidence sur la décision du comparateur 20.

Toutefois, un inconvénient d'un tel capteur est que l'excursion du signal DA entre les valeurs correspondant aux codes Code (0,...,0) et Code (1,...,1) doit maintenant correspondre à l'excursion du signal $S_T$, par exemple de l'ordre de 30 mV. En pratique, il peut être difficile de réaliser un convertisseur numérique-analogique 24 fournissant un signal DA avec une telle excursion.

La présente invention vise une mise en oeuvre particulière du capteur de température de la figure 3 qui permet de s'affranchir de l'inconvénient précédemment mentionné.

La figure 4 représente un exemple de réalisation du capteur de température selon l'invention dans lequel le convertisseur numérique-analogique 24 est un convertisseur à commutation de courant, par exemple un réseau en échelle (convertisseur R-2R). Le convertisseur 24 comprend une borne de sortie 26 recevant un courant $I_{DP}$ et une borne de sortie 28 recevant un courant $I_{DN}$.

Le générateur de tension de référence 18 est relié à la borne de sortie 26 à laquelle il applique la tension $V_{REF}$. Le capteur de température 30 fournit un courant $I_1$ à un noeud 32 relié à la borne de sortie 28 du convertisseur 24 et à une entrée d'un module d'égalisation de tension 34 (VOLT. EQ.). La tension de référence $V_{REF}$ est également fournie au module d'égalisation de tension 34. On appelle $I_E$ le courant circulant entre le noeud 32 et le module 34. Le courant $I_E$ est fourni par le module 34 à un convertisseur de courant en tension 36 (C.V.C) qui applique une tension $V_E$ entre les bornes du comparateur 20. Une liaison 38 est prévue entre le capteur de température 30 et le module de fourniture de la tension de référence 18.

Le fonctionnement du présent exemple de réalisation du capteur de température selon l'invention va maintenant être décrit.

Pour assurer un fonctionnement correct du convertisseur 24, les tensions aux bornes de sortie 26, 28 doivent être sensiblement constantes et égales. De façon classique, les bornes de sortie d'un convertisseur numérique-analogique à réseau en échelle à commutation de courant sont mises à la masse. Le présent exemple de réalisation de l'invention prévoit une polarisation originale du convertisseur 24 dans la mesure où les bornes de sortie 26, 28 du convertisseur 24 sont mises à une tension constante différente de la tension de masse du capteur. Pour ce faire, le générateur de tension de référence 18 applique la tension $V_{REF}$ à la borne 26 et le module d'égalisation 34 impose la tension $V_{REF}$ au noeud 28.

Le signal DA, fourni par le convertisseur 24, est obtenu par la relation suivante :

$$DA = I_{DN} - I_{DP} \qquad\qquad (10)$$

Le capteur de température 30 fournit un courant $I_1$ qui est égal à la somme d'un courant $I_T$ proportionnel à la température absolue et du courant $I_{DP}$. Le noeud 32 joue le rôle d'un soustracteur. Le courant $I_E$ fourni au module d'égalisation de tension 34 est donc obtenu par la relation suivante :

$$I_E = I_1 - I_{DN} = I_T + I_{DP} - I_{DN} = I_T - DAC \qquad\qquad (11)$$

La tension $V_E$ est proportionnelle au courant $I_E$ et est donc bien proportionnelle à la différence entre le signal $I_T$, proportionnel à la température absolue, et la conversion analogique du signal numérique Code codant le courant $I_T$. Le convertisseur de courant en tension 36 a simplement pour rôle d'assurer que la tension VE et le courant IE sont de même signe, le gain de ce convertisseur 36 important peu.

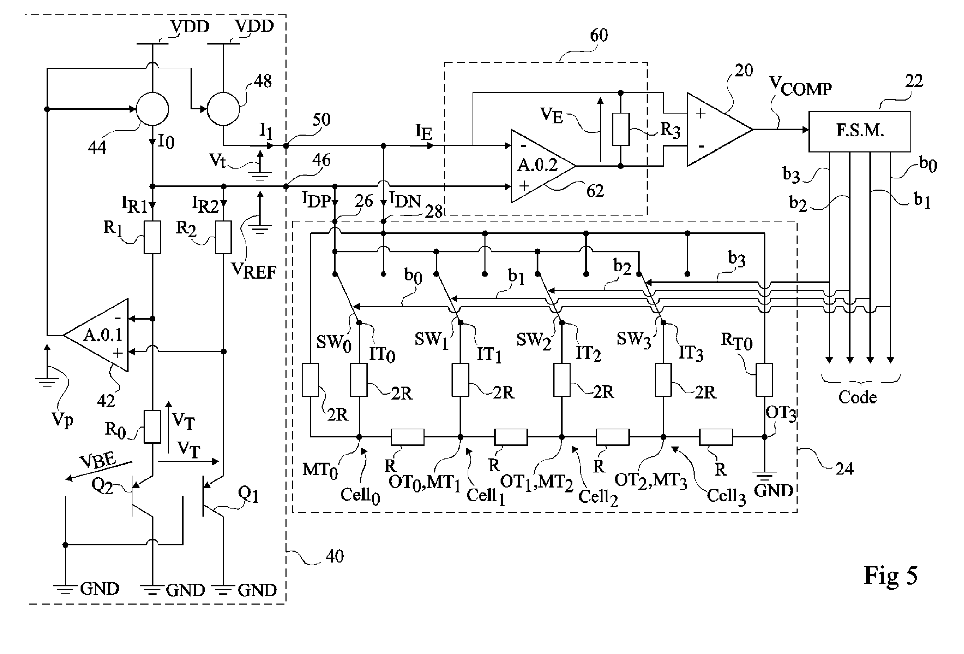

La figure 5 représente un exemple de réalisation plus détaillé du capteur de température de la figure 4. Selon le présent exemple de réalisation détaillé, les fonctions remplies par le capteur de température 30 et le module de fourniture de la tension de référence 18 sont assurées par un même circuit 40. Le circuit 40 comprend un premier transistor bipolaire $Q_1$ dont le collecteur et la base sont reliés à une source d'un potentiel de référence bas GND, par exemple la masse. L'émetteur du transistor $Q_1$ est relié à une borne positive (+) d'un amplificateur opérationnel 42 (A.O. 1). Le circuit 40 comprend un second transistor bipolaire $Q_2$ dont le collecteur et la base sont reliés à la masse GND. Une résistance $R_0$ relie l'émetteur du transistor $Q_2$ à l'entrée négative (-) de l'amplificateur 42. On appelle $V_T$ la tension entre l'émetteur du transistor $Q_1$ et l'émetteur du transistor $Q_2$ et $V_p$ la tension à la sortie de l'amplificateur 42.

Le circuit 40 comprend une source de courant commandée en tension 44 qui fournit un courant $I_0$. Une borne de la source de courant 44 est reliée à une source de potentiel de référence haut, par exemple VDD, l'autre borne de la source de courant 44 étant reliée à une première borne de sortie 46 du circuit 40. Le circuit 40 comprend une source de courant 48 commandée en tension, identique à la source de courant 44 et fournissant un courant $I_1$. Une borne de la source de courant 48 est reliée à l'alimentation VDD, l'autre borne de la source de courant 48 étant reliée à une seconde borne de sortie 50 du circuit 40. Les sources de courant 44, 48 sont commandées par la tension $V_p$ fournie par l'amplificateur 42. Une résistance $R_1$ relie l'entrée négative (-) de l'amplificateur 42 et la borne de sortie 50. Une résistance $R_2$ relie l'entrée positive (+) de l'amplificateur 42 et la borne de sortie 46. On note $I_{R1}$ et $I_{R2}$ les courants traversant respectivement les résistances $R_1$ et $R_2$. La tension $V_{REF}$ correspond à la tension sur la borne 46. On appelle $V_t$ la tension à la borne 50. La borne de sortie 50 est connectée à la borne de sortie 28 du convertisseur 24 et la borne de sortie 46 est connectée à la borne de sortie 26 du convertisseur 24.

Selon le présent exemple de réalisation, les fonctions remplies par le module d'égalisation de tension 34 et le module de conversion courant-tension 36 sont assurées par un même circuit 60. Le circuit 60 comprend un amplificateur opérationnel 62 (A.O.2) dont l'entrée négative (-) est connectée à la borne de sortie 28 du convertisseur 24 et dont l'entrée positive (+) est reliée à la borne de sortie 26 du convertisseur 24. L'entrée positive de l'amplificateur 62 est reliée à une borne d'une résistance $R_3$ dont l'autre borne est reliée à la sortie de l'amplificateur 62. La tension $V_E$ aux bornes de la résistance $R_3$ est appliquée entre les bornes du comparateur 20.

Le convertisseur 24 est du type à réseau en échelle à commutation de courant. Dans le présent exemple de réalisation, le nombre N de bits du signal Code est égal à 4. Le circuit 24 comprend une résistance $R_{T0}$ connectée entre la masse GND et la borne de sortie 28. Le circuit 24 comprend un empilement de N cellules. Chaque cellule $Cell_i$, i étant un entier compris entre 0 et N-1, comprend une borne d'entrée $IT_i$, une borne intermédiaire $MT_i$ et une borne de sortie $OT_i$, une résistance 2R reliant la borne d'entrée $IT_i$ à la borne intermédiaire $MT_i$ et une résistance R reliant la borne intermédiaire $MT_i$ à la borne de sortie $OT_i$. La borne de sortie $OT_i$ d'une cellule $Cell_i$ est connectée à la borne intermédiaire

$MT_{i+1}$ de la cellule $Cell_{i+1}$ adjacente. La borne de sortie $OT_{N-1}$ de la dernière cellule $Cell_{N-1}$ est reliée à la masse GND. Une résistance 2R relie la borne d'entrée $MT_0$ de la première cellule $Cell_0$ à la borne de sortie 28 du convertisseur 24. Chaque cellule $Cell_i$ comprend un interrupteur $SW_i$ commandé par le bit bi du signal Code et adapté à relier la borne d'entrée $IT_i$ à la borne 26 ou à la borne 28 de sortie du convertisseur 24 selon la valeur du bit $b_i$. A titre d'exemple, lorsque le bit $b_i$ est à "1", l'interrupteur $SW_i$ relie la borne d'entrée $IT_i$ de la cellule $Cell_i$ à la borne de sortie 28 et lorsque le bit $b_i$ est à "0", l'interrupteur $SW_i$ relie la borne d'entrée $IT_i$ de la cellule $Cell_i$ à la borne de sortie 26. Les transistors $SW_i$ peuvent être réalisés par des transistors MOS.

Le fonctionnement du présent exemple de réalisation du capteur de température selon l'invention va maintenant être décrit.

En appelant h le rapport des courants traversant les émetteurs des transistors $Q_1$ et $Q_2$ et m le rapport des surfaces des émetteurs des transistors $Q_1$ et $Q_2$, la tension $V_T$ est donnée par la relation suivante :

$$V_T = \lambda_T \cdot T = \frac{k \cdot T}{q} \ln(h \cdot m) \qquad (12)$$

où k est la constante de Boltzmann et où q est la charge d'un électron. La tension $V_T$ est donc proportionnelle à la température absolue. L'amplificateur 42 commande les sources de courant 44, 48 de sorte que la tension entre ses entrées positive et négative reste nulle. La tension aux bornes de la résistance $R_0$ est donc, en régime stabilisé, égale à $V_T$.

Par ailleurs, la tension $V_{REF}$ à la borne de sortie 46 est obtenue par la relation suivante :

$$V_{REF} = (1 + \frac{R_1}{R_0}) \cdot V_T - V_{BE} \qquad (13)$$

où $V_{BE}$ est la tension entre la base et l'émetteur du transistor $Q_2$. La tension $V_{BE}$ est obtenue par la relation suivante :

$$V_{BE} = V_{BE0} - \lambda_{BE} \cdot T - c(T) \qquad (14)$$

où $V_{BE0}$ et $\lambda_{BE}$ sont des termes constants et c(T) est un terme du second ordre qui dépend de la température.

On a alors :

$$V_{REF} = -V_{BE0} + [\lambda_T (1 + \frac{R_1}{R_0}) + \lambda_{BE}] \cdot T + c(T) = \alpha + \beta \cdot T + c(T) \qquad (15)$$

En choisissant les résistances $R_1$ et $R_0$ de façon adaptée, on peut annuler le coefficient $\beta$ et obtenir une tension $V_{REF}$ qui dépend de la température au second ordre, c'est-à-dire qui est sensiblement indépendante de la température.

Du fait de la régulation réalisée par l'amplificateur 62, la tension entre les entrées positive et négative de l'amplificateur 62 reste sensiblement nulle. Ceci permet d'assurer que la tension $V_t$ aux bornes 50 et 28 est en permanence sensiblement égale à $V_{REF}$. Le maintien de tensions constantes et égales aux bornes 26, 28 du convertisseur 24 en assure le bon fonctionnement.

On appelle $I_T$ la somme des courants $I_{R1}$ et $I_{R2}$. On a la relation suivante :

$$I_T = (1 + \frac{R_1}{R_2}) \cdot \frac{V_T}{R_0} \qquad (16)$$

La tension $V_T$ étant proportionnelle à la température absolue, le courant $I_T$ est lui-même proportionnel à la température absolue.

Les sources de courants 44 et 48 étant identiques et commandées toutes deux par la tension $V_p$, les courants $I_1$ et $I_0$ sont identiques et donnés par la relation suivante :

$$I_1 = I_0 = I_T + I_{DP} \qquad\qquad (17)$$

Les courants $I_{DP}$ et $I_{DN}$ sont donnés par les relations suivantes :

$$I_{DP} = \frac{V_{REF}}{2R} \sum_{i=0}^{N-1} \overline{b_i} \, 2^{i-N} \qquad\qquad (18)$$

et

$$I_{DP} + I_{DN} = (\frac{1}{2R} + \frac{1}{R_{T0}}) \cdot V_{REF} \qquad\qquad (19)$$

On obtient donc :

$$DA_{FS} = \frac{(1 - 2^{-N}) \cdot V_{REF}}{R} \qquad\qquad (20)$$

$$DA_0 = (\frac{1}{R_{T0}} - \frac{1 - 2^{-N+1}}{2R}) \cdot V_{REF} \qquad\qquad (21)$$

Le fait d'utiliser la différence $I_{DN}$-$I_{DP}$ comme signal DAC plutôt que directement le signal $I_{DP}$ permet de doubler l'excursion du convertisseur 24. Le paramètre $DA_{FS}$ peut facilement être modifié en faisant varier R et le paramètre $DA_0$ peut facilement être modifié en faisant varier $R_{T0}$. La résolution du présent exemple de réalisation du capteur peut facilement être augmentée en prévoyant des cellules supplémentaires au niveau du convertisseur numérique-analogique 24.

La présente invention permet d'obtenir un capteur de température comprenant un convertisseur analogique-numérique pouvant être facilement réalisé de façon intégrée. En outre, le capteur comporte un nombre réduit de composants et peut donc être réalisé de façon intégrée tout en occupant une surface réduite et en ayant une consommation limitée. Le présent exemple de réalisation du capteur limite les sources d'erreurs qui pourraient dégrader le signal numérique Code. En effet, la tension de référence est directement appliquée aux bornes du convertisseur 24, ce qui évite tout décalage dû à des recopies ou des stockages intermédiaires de la tension de référence. En outre, le comparateur 20 reçoit la tension aux bornes de la résistance $R_3$, ce qui permet de s'affranchir dans la comparaison du décalage induit par l'amplificateur 62. De plus, le convertisseur numérique-analogique 24 comprend seulement des résistances et des transistors qui peuvent facilement être réalisés avec précision. En outre, la précision du signal fourni par le convertisseur numérique-analogique 24 ne dépend au premier ordre que des résistances car les transistors qu'il contient sont utilisés en interrupteurs et n'interviennent qu'au deuxième ordre.

Bien entendu, la présente invention est susceptible de diverses variantes et modifications qui apparaîtront à l'homme de l'art. En particulier, le module de codage 22 est à adapter au procédé de conversion analogique-numérique choisi. A titre d'exemple, pour une conversion analogique-numérique à rampe numérique, le module de codage 22 peut comprendre une porte ET recevant le signal $V_{COMP}$ et un signal d'horloge, la sortie de la porte attaquant un compteur qui fournit le signal Code.

**Revendications**

1. Capteur de température fournissant un signal numérique (Code) représentatif de la température, comportant :

un module de mesure (30 ; 40) fournissant un premier courant de mesure (I$_1$) égal à la somme d'au moins un premier courant proportionnel à la température et d'un deuxième courant (I$_{DP}$) ;

un comparateur (20) adapté à fournir un signal de comparaison (V$_{COMP}$) qui dépend de la comparaison entre le premier courant et la différence entre un troisième courant (I$_{DN}$) et le deuxième courant (I$_{DP}$) ;

un module de codage (22) recevant le signal de comparaison et fournissant ledit signal numérique ;

un convertisseur numérique-analogique (24) à commutation de courant adapté à fournir le second courant à une première borne de sortie (26) et le troisième courant à une seconde borne de sortie (28), ladite différence correspondant à la conversion dudit signal numérique, le module de mesure étant relié à la première borne de sortie ; et

un module (18, 34 ; 40, 60) de fourniture d'une tension de référence (V$_{REF}$) aux première et seconde bornes de sortie ayant une valeur distincte de la tension de masse (GND) du capteur.

2. Capteur selon la revendication 1, comportant un module de fourniture (18 ; 40) de ladite tension de référence (V$_{REF}$) à la première borne de sortie (26) et un module (34 ; 60) adapté à appliquer la tension de référence à la seconde borne de sortie (28).

3. Capteur selon la revendication 2, comportant un premier amplificateur opérationnel (62) ayant une première entrée reliée à la première borne de sortie (26) et une seconde entrée reliée à la seconde borne de sortie (28), et une résistance (R$_3$) reliant la seconde entrée et la sortie du première amplificateur opérationnel, le comparateur (20) comportant un second amplificateur opérationnel ayant des troisième et quatrième entrées, la tension (V$_E$) aux bornes de la résistance étant appliquée entre les troisième et quatrième entrées du second amplificateur opérationnel.

4. Capteur selon la revendication 1, dans lequel le signal numérique (Code) comporte un nombre entier N de bits (b$_0$, b$_1$, b$_2$, b$_3$) de rangs 0 à N-1, le bit de rang N-1 (b$_3$) étant de poids le plus significatif, et dans lequel le convertisseur numérique-analogique (24) est un réseau en échelle comportant N cellules (Cell$_0$, Cell$_1$, Cell$_2$, Cell$_3$) successives, comportant chacune :

un noeud d'entrée (IT$_0$, IT$_1$, IT$_2$, IT$_3$), un noeud intermédiaire (MT$_0$, MT$_1$, MT$_2$, MT$_3$) et un noeud de sortie (OT$_0$, OT$_1$, OT$_2$, OT$_3$) ;

une première résistance (2R) à une première valeur de résistance entre le noeud d'entrée et le noeud intermédiaire ;

une deuxième résistance (R) à une deuxième valeur de résistance entre le noeud intermédiaire et le noeud de sortie, le noeud de sortie d'une cellule de rang i, où i est un entier compris entre 0 et N-2, étant relié au noeud intermédiaire de la cellule de rang i+1 ; et

un interrupteur (SW$_0$, SW$_1$, SW$_2$, SW$_3$) adapté à relier le noeud d'entrée à la première borne de sortie (26) ou à la seconde borne de sortie (28) en fonction de la valeur du bit de rang i dudit signal numérique,

et dans lequel le noeud de sortie (OT$_3$) de la cellule (Cell$_3$) de rang N-1 est relié à la masse (GND) du capteur, une troisième résistance (R) à la première valeur de résistance reliant le noeud intermédiaire (MT$_0$) de la cellule (Cell$_0$) de rang 0 à la seconde borne de sortie.

5. Capteur selon la revendication 4, comprenant en outre une quatrième résistance (RTO) reliant le noeud de sortie de la cellule de rang N-1 à la seconde borne de sortie (28).

6. Capteur selon la revendication 1, dans lequel le module (40) de fourniture de la tension de référence (V$_{REF}$) comprend :

des premier et second transistors bipolaires (Q$_1$, Q$_2$) dont les bases et les collecteurs sont reliés à la masse (GND) du capteur ;

un amplificateur opérationnel (42) ayant une première entrée reliée à la première borne de sortie (26) par l'intermédiaire d'une première résistance (R$_2$) et à l'émetteur du premier transistor (Q$_1$) et une seconde entrée reliée à la première borne de sortie par l'intermédiaire d'une deuxième résistance (R$_1$) et à l'émetteur du second transistor (Q$_2$) par l'intermédiaire d'une troisième résistance (R$_0$), ledit amplificateur opérationnel fournissant une tension de commande (Vp) ; et

une source de courant (44) commandée par la tension de commande et reliée à la première borne de sortie.

7. Capteur selon la revendication 6, dans lequel le module de mesure (40) comprend une source de courant (48) supplémentaire commandée par la tension de commande (V$_p$) et reliée à la seconde borne de sortie (28).

Fig 1

Fig 2

Fig 3

Fig 4

Fig 5

**Office européen des brevets**

**RAPPORT DE RECHERCHE EUROPEENNE**

Numéro de la demande

EP 07 11 3686

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 2004/227651 A1 (FURUICHI SHUJI [JP]) 18 novembre 2004 (2004-11-18) * abrégé; figure 10 * * alinéa [0066] * * alinéa [0104] - alinéa [0107] * ----- | 1-7 | INV. G01K1/02 H03M1/18 |
| A | US 2002/105449 A1 (SCHREIER RICHARD [US] ET AL) 8 août 2002 (2002-08-08) * figures 4,5 * * alinéa [0032] * ----- | 1-7 | |
| A | DE 10 2004 030812 A1 (INFINEON TECHNOLOGIES AG [DE]) 29 septembre 2005 (2005-09-29) * abrégé; figure 5 * * alinéa [0064] - alinéa [0068] * ----- | 1-7 | |
| A | US 5 241 310 A (TIEMANN JEROME J [US]) 31 août 1993 (1993-08-31) * colonne 3, ligne 55 - colonne 4, ligne 57 * * colonne 5, ligne 17 - ligne 49 * ----- | 1-7 | **DOMAINES TECHNIQUES RECHERCHES (IPC)** G01K H03M |

Le présent rapport a été établi pour toutes les revendications

| Lieu de la recherche | Date d'achèvement de la recherche | Examinateur |
|---|---|---|
| Munich | 26 octobre 2007 | Pisani, Francesca |

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 07 11 3686

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

26-10-2007

| Document brevet cité au rapport de recherche | Date de publication | Membre(s) de la famille de brevet(s) | Date de publication |
|---|---|---|---|
| US 2004227651 A1 | 18-11-2004 | JP 3807381 B2<br>JP 2004274166 A | 09-08-2006<br>30-09-2004 |
| US 2002105449 A1 | 08-08-2002 | AUCUN | |
| DE 102004030812 A1 | 29-09-2005 | CN 1943117 A | 04-04-2007 |
| US 5241310 A | 31-08-1993 | AUCUN | |

EPO FORM P0460